# EUROPEAN PATENT APPLICATION

(11) **EP 3 431 621 A1**
(43) Date of publication of application: **23.01.2019**
(21) Application number: 17900207.6
(22) Date of filing: 24.04.2017
(51) Int. Cl.: C22C 13/00, C22C 30/06, C22C 1/02

(54) **LIQUID METAL THERMAL INTERFACE MATERIAL WITH MELT-BACK PROPERTY AND PREPARATION METHOD THEREOF**

(30) Priority: 09.03.2017 CN 201710138707
(71) Applicant: Ningbo Syrnma Metal Materials Co. Ltd., Ningbo, Zhejiang 315000 (CN)
(72) Inventor: LIU, Yajun, Ningbo Zhejiang 315000 (CN); CAO, Hequan, Ningbo Zhejiang 315000 (CN); CAO, Shuai, Ningbo Zhejiang 315000 (CN); GUO, Qiang, Ningbo Zhejiang 315000 (CN); WU, Zhixin, Ningbo Zhejiang 315000 (CN)
(74) Representative: Grünecker Patent- und Rechtsanwälte PartG mbB
(86) International application number: PCT/CN2017/081749
(87) International publication number: WO 2018/161416

(57) **Abstract**

The present invention discloses a liquid metal thermal interface material having an anti-melt characteristic and a preparation method thereof. The liquid metal thermal interface material is characterized by comprising, In percentage by weight, 20-40wt% of indium, 0-6wt% of bismuth, 0-2wt% of antimony, 0-3wt% of zinc, 0-0.6wt% silver, 0-0.3wt% of nickel, 0-0.8wt% of cerium, 0-0.6wt% of europium and the balance of tin. The liquid metal thermal interface material has excellent thermal conductivity and chemical stability in an operating environment of an insulated gate bipolar transistor (IGBT), and thus is very suitable for IGBT devices in large-scale Industrial production and practical applications.

## Description

### Field of the Invention

The present invention relates to a liquid metal thermal interface material having an anti-melt characteristic and a preparation method thereof, and particularly to a liquid metal thermal interface material for an insulated gate bipolar transistor (IGBT) system and a preparation method thereof.

### Background of the Invention

As is well known, IGBT devices have become mainstream devices in today's development of power semiconductor devices and been extensively applied to power electronic circuits in various fields of AC motors, frequency converters, switching power supplies, lighting circuits, traction drive and the like due to their characteristics of high input resistance, high switching speed, low on-state voltage, high block voltage and large rated current.

However, while an IGBT device is running, the heat produced may cause rapid rise of the temperature of a chip beyond a maximum allowable IGBT junction temperature. It thus may cause a great degradation in performance of the IGBT and unsteady operation, resulting in degraded performance or failure. In recent years, due to the further development of the IGBT technique, the related high-efficiency heat dissipation technique in extreme environments has become a critical technical problem that thermal management engineers and scientists all desire to solve.

An integral IGBT module consists of four parts: an IGBT device, a radiator, a hot air fan and a heat-conducting medium, wherein the IGBT device itself and the heat-conducting medium play a decisive role in heat dissipation performance. Microscopic holes are evident in contact surfaces of a heating element and a radiator, which are full of air. As air is a poor heat conductor, thermal interface resistance between the heating element and the radiator is very high, which seriously hinders heat conduction and therefore results in low heat dissipation efficiency. A thermal interface material having a high thermal conductivity may fill up such microscopic holes and help establish an effective heat conduction channel, thereby greatly reducing the thermal interface resistance. Therefore, it has been desirable to develop a thermal interface material having high heat transfer performance.

Patent document 1 discloses a nano-sllver paste as a thermal interface material with high heat transfer performance, which is intended to improve the instability of electrical performance of a crimping-type IGBT module due to large thermal resistance and quick temperature rise of the module. However, it must be noted that the nano-silver paste in this patent document is still an alloy material having a normal melting behavior. When it is used as a thermal interface material to fill up holes between a heating element and a radiator, It is still a thermal interface material operating in a solid state, and no liquid metal thermal interface material in a solid-liquid state at an operating temperature and having the anti-melt characteristic is provided.

Patent document 2 discloses a high-thermal conductivity silicone rubber thermal interface material functionally modified by polydopamine to solve the problems that an LED finished product is low In thermal conductivity and that 100% filler surface being coated cannot be guaranteed even though surface treatment is carried out using a silane coupling agent. However, it must be noted that the thermal interface material is still prepared from organic matters. Comparing to high thermal conductivity of a metal, the patent document 2 just provides a thermal interface material having a relatively low heat dissipation coefficient. It can not melt at an operating temperature and has no anti-melt characteristic to fill up holes between a heating element and a radiator more effectively.

The prior art documents: patent document 1, publication No. CN106373954A; patent document 2, publication No. CN106317887A.

### Summary of the Invention

With the rapid development of the electronic technology, a great amount of heat produced by electronic chips has become a serious problem in the field of heat management, especially for IGBT systems. At present, silicone grease is often used to fill up spaces between a heat source and a radiator. However, its thermal conductivity is very low, typically less than 3W/m·K, which seriously hinders its large-scale application in the field of electronic heat dissipation.

As a new high-efficiency heat dissipating material (having a thermal conductivity of about 40-85w/m·K), a liquid metal has been considered as an ultimate effective solution for heat management of an IGBT device in extreme conditions. Unfortunately, a side leakage is likely to occur in a traditional liquid metal used as a thermal interface material at a temperature near a melting point thereof, which may cause short circuit of an electronic chip.

An ideal thermal interface material should possess the following physical and chemical characteristics: (1) high thermal conductivity to ensure effective heat dissipation; (2) good flowability to effectively fill up micro voids between a heating element and a radiator; and (3) unique flexibility of installation under low pressure. Silicone grease is a traditional thermal interface material for heat conduction of an electronic device, but has an extremely low heat transfer coefficient (1-2W/m·K). Moreover, after serving for a long time, the silicone grease may become fragile and aged due to the evaporation and oxidation of organic constituents. By contrast, liquid metals emerging in recent years are at the top of a pyramid in the field of heat dissipation for their extremely low vapor pressure and oxidation resistance in addition to extremely high thermal conductivity, and particularly applicable to high-density high-power electronic components and parts.

A liquid metal is a low-melting point alloy with a high thermal conductivity (20-85 W/m·K) near the melting point thereof. Based on physical states under operation conditions, liquid metals may be categorized into three types: (1) completely liquid metals having a melting point that may decrease to about 2°C. This type of liquid metals may be driven by an electromagnetic pump to serve as a cooling medium in a radiating pipe to improve the heat dissipation efficiency. (2) Paste-like liquid metals having a melting point up to 50°C and capable of keeping a solid-liquid state within a broad temperature range. This type of liquid metals may serve as thermal interface material to replace the silicone grease. (3) Foil-like liquid metals having a melting point within a range of 60°C to 180°C when used as a thermal interface material. The three types of liquid metals are nontoxic, have stable physical/chemical properties, and are suitable for long-term use under extreme conditions. Particularly, the foil-like liquid metals are expected to be applied to a production line on a maximum scale due to flexibility of installation.

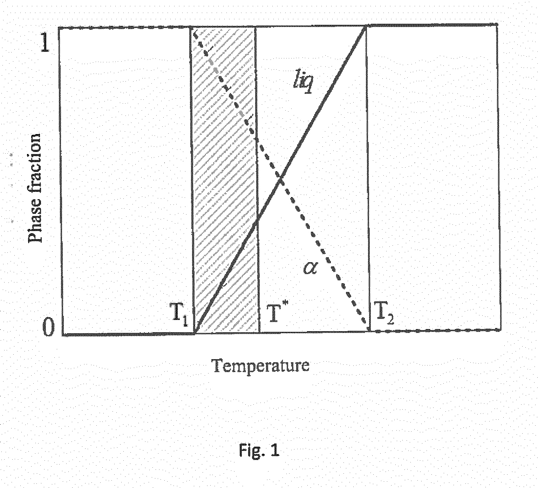

As is well known, a foil-like liquid metal exhibits a solid-liquid state near its melting point. In such a state, the foil-like liquid metal exhibits a unique and effective void filling capability. For a normal foil-like liquid metal, a liquid phase fraction in both solid-liquid phases increases with increasing temperature. Fig. 1 is a schematic diagram illustrating variations of a liquid phase and a solid phase of a common foil-like liquid metal with temperature during heating. A melting temperature range of the alloy is as follows: the alloy begins to melt at temperature T₁ and stops melting at temperature T₂. Therefore, the alloy keeps in a solid-liquid mixed state within a temperature range of ΔT=T₂-T₁, which indicates that the alloy is melting. T* is a temperature where a liquid phase at the highest temperature may be allowed to serve as a thermal interface material. Thus, such a material may serve as the thermal interface material within a shadow area (ΔT=T*-T₁) marked in Fig. 1. When the temperature further increases, the liquid phase increases rapidly, and a side leaking liquid metal thermal interface material may cause short circuit of a circuit board. It is fundamentally because the increased liquid phase fraction greatly enhances the flowability of the solid-liquid mixture.

Fig. 1 is a schematic diagram illustrating variations of a phase fraction of a foil-like liquid metal in a normal melting state with temperature (this system comprises only a liquid phase and α phase).

Through long-term study, the inventor has found an effective method to overcome side leakage of a liquid metal caused by an Increased content of the liquid phase during melting, and thus designs a new liquid metal that has an anti-melt characteristic.

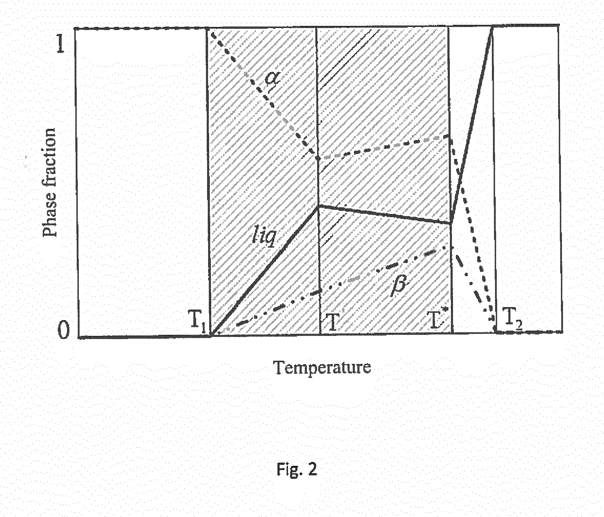

For the sake of convenient description of the anti-melt characteristic of the material, a schematic diagram in Fig. 2 is used as an example for description. The system comprises three phases, i.e., liquid phase, α phase and β phase. The melting behavior of the alloy between T₁ and T' in this figure is consistent with that in Fig.1. However, when the alloy continues to melt as the temperature rises, the fraction of the liquid phase decreases sharply with increasing temperature, accompanied by an increase in the fraction of the α phase and β phase. Generally, an anti-melt behavior is defined as a melting behavior In a temperature interval between T' and T* in Fig.2, i.e., the fraction of the liquid phase sharply decreasing with Increasing temperature. Once the temperature exceeds T* in Fig.2, the fraction of the liquid phase sharply increases with increasing temperature until the alloy melts completely. In addition, the decreased liquid phase between the temperatures T' and T* may also can reduce the flowability of the liquid metal, and this characteristic is particularly significant for serving as a thermal interface material. The shadow area in Fig. 2 is a temperature interval where the material is suitable as the thermal interface material. Apparently, a foil-like liquid metal thermal interface material having an anti-melt characteristic may have a wider operating temperature range as compared to a common foil-like liquid metal.

Fig. 2 Is a schematic diagram illustrating variations of a phase fraction of a foil-like liquid metal in an anti-melt state with temperature (this system comprises a liquid phase, α phase and β phase).

The melting and the phase content of an alloy are closely associated with the thermodynamic properties of the alloy. Therefore, theoretically, it is possible to design a foil-like liquid metal having the anti-melt behavior based on a phase diagram. Generally, a phase diagram of a c-component system is c-dimensional, and consists of a single-phase zone, a two-phase zone, a three-phase zone... a c-phase zone. By using a novel material design technique, appropriate alloy constituents may be found so that the alloy has the anti-melt behavior when used as a liquid metal, as shown in Fig.2. In other words, the flowability of a foil-like liquid metal in a solid-liquid state may be customized to prevent side leakage of the liquid metal, and the thermal conductivity can be improved to an utmost extent. Besides, such a design method may provide a foil-like liquid metal having an anti-melt characteristic for use within a temperature range of 60°C to 180°C for an IGBT system.

Based on the above novel material design technique, the present invention provides a liquid metal thermal interface material having an anti-melt characteristic for heat dissipation of IGBTs. Operating temperatures of suitable IGBT heat dissipation systems range from 60°C to 180°C. The liquid metal thermal interface material having the anti-melt characteristic is produced through alloy smelting, casting, heat treatment and cold rolling processes.

That is, the present disclosure includes the following invention:
(1) A liquid metal thermal interface material having an anti-melt characteristic is characterized by comprising, in percentage by weight, 20-40wt% of indium, 0-6wt% of bismuth, 0-2wt% of antimony, 0-3wt% of zinc, 0-0.6wt% silver, 0-0.3wt% of nickel, 0-0.8wt% of cerium, 0-0.6wt% of europium and the balance of Sn.
(2) The liquid metal thermal interface material according to above (1) has an anti-melt temperature ranging from 64°C to 180°C. Such a material starts melting at a temperature ranging from 60°C to 140°C, and keeps In a solid-liquid state between 60°C and 200°C, with a related anti-melt temperature ranging from 64°C to 180°C, depending on the selected alloy constituents.
(3) The liquid metal thermal interface material according to above (1) or (2) is suitable for heat dissipation of an IGBT system within a temperature range of 60°C to 180°C.
(4) A method of preparing the liquid metal thermal interface material according to above (1) to (3) is characterized in that: using argon/nitrogen as a protective atmosphere, and performing induction melting of a material mixed according to the alloy composition of above (1) to (3) In a graphite crucible by using an Induction smelting technique, and then stirring at a temperature ranging from 400°C to 500°C for about 10 minutes. The specific temperatures are selected according to the selected alloy constituents. The uniformly-stirred alloy melt is then poured into a graphite mold for solidification, and heat treatment is performed on the solidified alloy Ingots at a temperature ranging from 40°C to 140°C for 2 to 4 hours. The purpose of the heat treatment is to achieve sufficient phase precipitation of the alloy, which is conducive to improving the mechanical properties of the material and facilitates further cold rolling. The further cold rolling is carried out afterwards.
(5) In the preparation method of the liquid metal thermal interface material according to above (4), a rolling quantity per pass in the cold rolling is 20-30%. The heat treated alloy ingots may be cold rolled at the room temperature to a required thickness, such as 0.05 mm. The rolling quantity per pass is 20-30% depending on the selected alloy constituents.

The present invention has the following advantages:
(1) The foil-like liquid metal thermal interface material in the present invention has sufficient temperature ranges and possesses an anti-melt characteristic. The material keeps in a solid-liquid state with a sufficient solid phase content within these temperature ranges. As enough viscosity is provided to prevent side leakage, short circuit of an electronic system can be avoided completely. An ultimate solution can be absolutely carried out for the heat dissipation requirements of IGBTs today with increasingly rigid heat dissipation requirements.
(2) Such a foil-like liquid metal thermal interface material may be manufactured through simple steps, including induction smelting, casting, heat treatment and cold rolling. Despite low production cost, the product has excellent thermal conductivity and chemical stability in operating environments of IGBT. It is very applicable for IGBT devices in large-scale industrial production and practical applications.
(3) The liquid metal thermal interface material having the anti-melt characteristic provides an effective solution at the top of a heat dissipation pyramid for heat dissipation in extreme conditions. It can promote rapid development in many new industrial fields in practice, especially for high heat-flow density electronic devices. It is expected that the related products of the present invention will certainly be applied on a large scale to the fields of information and telecommunications, advanced energy, photovoltaic industry, space application, advanced weapon systems and advanced electronics soon in the future.

### Brief Description of the Drawings

Fig. 1 is a schematic diagram illustrating variations of a phase fraction of a foil-like liquid metal in a normal melting state with temperature, wherein the system comprises only a liquid phase and α phase.
Fig. 2 is a schematic diagram illustrating variations of a phase fraction of a foil-like liquid metal in an anti-melt state with temperature, wherein the system comprises a liquid phase, α phase and β phase.

### Detailed Description of the Invention

The present invention will be described in more details below through embodiments. However, the present invention is not limited to such embodiments.

### Embodiment 1: preparation of a liquid metal thermal interfacial material 1 in the present invention.

Alloy raw materials are prepared in the following percentages by weight: 22wt% indium, 1.4wt% bismuth, 0.3wt% of antimony, 1.6wt% of zinc, 0.05wt% silver, 0.02wt% of nickel, 0.02wt% of cerium, 0.01wt% of europium and the balance of Sn.

The above alloy constituents are subjected to induction smelting in a graphite crucible with argon or nitrogen as a protective atmosphere. The temperature is kept at 420°C, and the materials are electromagnetically stirred for 10 minutes to fine homogenization. Next, the molten alloy liquid Is poured into a graphite mold for casting. After the alloy solidifies, the alloy ingots are subjected to heat treatment for 3 hours at 40°C to ensure complete precipitation of a second phase in the alloy and excellent mechanical properties of the alloy. Cold rolling is carried out at a room temperature afterwards, and a thickness of 0.05mm is obtained through several passes of rolling, wherein the rolling quantity per pass is 24%.

The alloy material obtained is a foil-like liquid metal that begins melting at about 60°C and keeps a solid-liquid state between 60°C and 74°C. The foil-like liquid metal has an anti-melt characteristic within a range of 62°C to 68°C, and can be well applied to heat dissipation of a system of which an IGBT heat source temperature is below 68°C.

### Embodiment 2: preparation of a liquid metal thermal interfacial material 2 in the present invention

Alloy raw materials are prepared in the following percentages by weight: 28wt% indium, 1.9wt% bismuth, 0.4wt% of antimony, 1.8wt% of zinc, 0.03wt% silver, 0.01wt% of nickel, 0.01wt% of cerium, 0.02wt% of europium and the balance of Sn.

The above alloy constituents are subjected to induction smelting in a graphite crucible with argon or nitrogen as a protective atmosphere. The temperature is kept at 420°C, and the materials are electromagnetically stirred for 10 minutes to fine homogenization. Next, the molten alloy liquid is poured into a graphite mold for casting. After the alloy solidifies, the alloy ingots are subjected to heat treatment for 3 hours at 80°C to ensure complete precipitation of a second phase in the alloy and excellent mechanical properties of the alloy. Cold rolling is carried out at a room temperature afterwards, and a thickness of 0.05mm is obtained through several passes of rolling, wherein the rolling quantity per pass is 28%.

The alloy material obtained Is a foil-like liquid metal that begins melting at about 84°C and keeps a solid-liquid state between 84°C and 115°C. The foil-like liquid metal has an anti-melt characteristic within a range of 92°C to 108°C, and can be well applied to heat dissipation of a system of which an IGBT heat source temperature is below 110°C.

### Embodiment 3: preparation of a liquid metal thermal interfacial material 3 in the present invention

Alloy raw materials are prepared in the following percentages by weight: 32wt% indium, 2.1wt% bismuth, 0.6wt% of antimony, 2.9wt% of zinc, 0.02wt% silver, 0.03wt% of nickel, 0.02wt% of cerium, 0.01wt% of europium and the balance of Sn.

The above alloy constituents are subjected to induction smelting in a graphite crucible with argon or nitrogen as a protective atmosphere. The temperature is kept at 420°C, and the materials are electromagnetically stirred for 10 minutes to fine homogenization. Next, the molten alloy liquid is poured into a graphite mold for casting. After the alloy solidifies, the alloy ingots are subjected to heat treatment for 3 hours at 100°C to ensure complete precipitation of a second phase In the alloy and excellent mechanical properties of the alloy. Cold rolling is carried out at a room temperature afterwards, and a thickness of 0.05 mm is obtained through several passes of rolling, wherein the rolling quantity per pass is 30%.

The alloy material obtained is a foil-like liquid metal that begins melting at about 118°C and keeps a solid-liquid state between 118°C and 142°C. The foil-like liquid metal has an anti-melt characteristic within a range of 124°C to 132°C, and can be well applied to heat dissipation of a system of which an IGBT heat source temperature is below 140°C.

The present invention may be used in an insulated gate bipolar transistor (IGBT) system

## Claims

1. A liquid metal thermal interface material having an anti-melt feature **characterized In that**, comprising, in percentage by weight, the following constituents in specific proportions: 20-40wt% of indium, 0-6wt% of bismuth, 0-2wt% of antimony, 0-3wt% of zinc, 0-0.6wt% silver, 0-0.3wt% of nickel, 0-0.8wt% of cerium, 0-0.6wt% of europium and the balance of tin.

2. The liquid metal thermal interface material according to claim 1, **characterized in that**, comprising, in percentage by weight, the following constituents In specific proportions: 22wt% indium, 1.4wt% bismuth, 0.3wt% of antimony, 1.6wt% of zinc, 0.05wt% silver, 0.02wt% of nickel, 0.02wt% of cerium, 0.01wt% of europium and the balance of tin.

3. The liquid metal thermal Interface material according to claim 1, **characterized in that**, comprising, In percentage by weight, the following constituents in specific proportions: 28wt% indium, 1.9wt% bismuth, 0.4wt% of antimony, 1.8wt% of zinc, 0.03wt% silver, 0.01wt% of nickel, 0.01wt% of cerium, 0.02wt% of europium and the balance of tin.

4. The liquid metal thermal interface material according to claim 1, **characterized in that**, comprising, in percentage by weight, the following constituents in specific proportions: 32wt% Indium, 2.1wt% bismuth, 0.6wt% of antimony, 2.9wt% of zinc, 0.02wt% silver, 0.03wt% of nickel, 0.02wt% of cerium, 0.01wt% of europium and the balance of tin.

5. The liquid metal thermal interface material according to any one of claims 1-4, **characterized in that** an anti-melt temperature thereof ranges from 64°C to 180°C.

6. The liquid metal thermal interface material according to any one of claims 1-4, **characterized in that** applicable to heat dissipation of an insulated gate bipolar transistor (IGBT) system within a temperature range of 60°C to 180°C.

7. A preparation method of the liquid metal thermal interface material according to any one of claims 1-4, **characterized in that** the method specifically comprising:
1) using argon/nitrogen as a protective atmosphere and carrying out induction melting of a material mixed according to the proportions of the constituents in a graphite crucible;
2) stirring at a temperature ranging from 400°C to 500°C to fine homogenization;
3) pouring the uniformly-stirred alloy melt into a graphite mold for solidification; and
4) performing heat treatment on solidified alloy Ingots at a temperature ranging from 40°C to 140°C for 2 to 4 hours, and then carrying out further cold rolling treatment.

8. The preparation method according to claim 7, **characterized in that** a rolling quantity per pass in the cold rolling is 20-30%.
